(19) Europäisches Patentamt / European Patent Office / Office européen des brevets

(11) **EP 1 327 289 B1**

(12) **FASCICULE DE BREVET EUROPEEN**

(45) Date de publication et mention de la délivrance du brevet:
**29.07.2009 Bulletin 2009/31**

(51) Int Cl.:
***H01S 5/14*** *(2006.01)*

(21) Numéro de dépôt: **01980595.1**

(86) Numéro de dépôt international:
**PCT/FR2001/003129**

(22) Date de dépôt: **10.10.2001**

(87) Numéro de publication internationale:
**WO 2002/031934 (18.04.2002 Gazette 2002/16)**

(54) **SOURCE LASER MONOMODE ACCORDABLE EN LONGUEUR D'ONDE-------------**

MONOMODE ABSTIMMBARE LASERQUELLE

WAVELENGTH TUNABLE LASER SOURCE

(84) Etats contractants désignés:
**AT BE CH CY DE DK ES FI FR GB GR IE IT LI LU MC NL PT SE TR**

(30) Priorité: **10.10.2000 FR 0012958**

(43) Date de publication de la demande:
**16.07.2003 Bulletin 2003/29**

(73) Titulaire: **YENISTA OPTICS SA**
**22300 Lannion (FR)**

(72) Inventeurs:
• **LEFEVRE, Hervé**
  **F-75014 PARIS (FR)**
• **GRAINDORGE, Philippe**
  **F-75015 PARIS (FR)**
• **ROOSEN, Gérald**
  **F-78720 LA CELLE LES BORDES (FR)**
• **JONATHAN, Jean-Michel**
  **F-92310 SEVRES (FR)**
• **PAULIAT, Gilles**
  **F-91940 PARIS (FR)**

(74) Mandataire: **Maillet, Alain**
  **Cabinet Le Guen & Maillet**
  **5, place Newquay**
  **B.P. 70250**
  **35802 Dinard Cedex (FR)**

(56) Documents cités:
  **EP-A- 1 006 628          US-A- 5 594 744**

• **WHITTEN W B ET AL: "MODE SELECTION IN A CONTINUOUS-WAVE DYE LASER WITH AN INTRACAVITY PHOTOREFRACTIVE ELEMENT" OPTICS LETTERS, OPTICAL SOCIETY OF AMERICA, WASHINGTON, US, vol. 12, no. 2, 1 février 1987 (1987-02-01), pages 117-119, XP000710524 ISSN: 0146-9592**
• **AKIRA SHIRATORI ET AL: "FREQUENCY-STABEL, NARROW LINEWIDTH OSCILLATION OF RED DIODE LASER WITH PHASE-CONJUGATE FEEDBACK USING STIMULATED PHOTOREFRACTIVE BACKSCATTERING" APPLIED PHYSICS LETTERS, AMERICAN INSTITUTE OF PHYSICS. NEW YORK, US, vol. 69, no. 11, 9 septembre 1996 (1996-09-09), pages 1515-1516, XP000628878 ISSN: 0003-6951**
• **RAMSEY J M ET AL: "CONTROLLED SCANNING OF A CONTINUOUS-WAVE DYE LASER WITH AN INTRACAVITY PHOTOFEFRACTIVE ELEMENT" OPTICS LETTERS, OPTICAL SOCIETY OF AMERICA, WASHINGTON, US, vol. 12, no. 11, 1 novembre 1987 (1987-11-01), pages 915-917, XP000713048 ISSN: 0146-9592 cité dans la demande**

EP 1 327 289 B1

## Description

La présente invention concerne une source laser monomode accordable en longueur d'onde à cavité externe.

On sait qu'une cavité optique résonnante d'une source laser sélectionne une ou plusieurs longueurs d'onde émises par un milieu amplificateur laser. Il s'agit le plus souvent de deux miroirs dont l'un partiellement transparent, formant une cavité dite de Fabry-Perot. Une telle cavité de Fabry-Perot sélectionne, ou résonne pour des demi-longueurs d'onde égales à des sous-multiples de la longueur optique $L_{op}$ de la cavité et donc en général très proches les unes des autres. Plusieurs longueurs d'onde sont alors susceptibles d'être amplifiées par le milieu amplificateur à spectre large. On obtient ainsi un laser multimode.

Pour certaines applications, des lasers monomodes sont préférés. Il est alors nécessaire de mettre en oeuvre une cavité optique résonnante associant un moyen de sélection complémentaire de la cavité de Fabry-Perot, par exemple de remplacer l'un de ses miroirs par un dispositif dispersif rétroréfléchissant.

Les dispositifs dispersifs rétroréfléchissants sont couramment utilisés en optique traditionnelle. Le dispositif le plus connu est probablement le réseau plan de pas p utilisé selon la configuration de Littrow.

De manière générale, un réseau plan de pas p a un plan de dispersion perpendiculaire à ses traits. Un faisceau lumineux collimaté de longueur d'onde λ, incliné d'un angle $\theta_1$ par rapport à la normale du réseau qui est parallèle au plan de dispersion du réseau, produit un faisceau collimaté également parallèle au plan de dispersion et ayant une direction inclinée d'un angle $\theta_2$ par rapport à la normale, $\theta_1$ et $\theta_2$ étant liés par la relation :

$$p \sin \theta_1 + p \sin \theta_2 = \lambda$$

Dans les sources lasers accordables à cavité externe fonctionnant avec une configuration dite de Littman-Metcalf où le faisceau collimaté incident fait un angle $\theta_1$ avec la normale au réseau, un miroir additionnel est placé avec sa normale ayant un angle $\theta_2$ sur le réseau. La longueur d'onde λ qui respecte $\lambda = p \sin \theta_1 + p \sin \theta_2$ est dispersée par le réseau à un ange $\theta_2$, puis est rétroréfléchie sur le miroir qui lui est alors perpendiculaire, et enfin est dispersée de nouveau dans le réseau en retour et ressort à l'angle $\theta_1$ d'entrée. Cette longueur d'onde λ est donc sélectionnée dans la cavité. L'accordabilité en longueur d'onde est obtenue en faisant varier l'orientation de l'ensemble réseau-miroir, c'est-à-dire en faisant varier $\theta_1$, ou bien en faisant varier uniquement l'orientation du miroir, c'est-à-dire en faisant varier $\theta_2$ ou enfin en faisant varier uniquement l'orientation du réseau, c'est-à-dire en faisant varier $\theta_1$ et $\theta_2$ tout en conservant $\theta_1$ - $\theta_2$ contant.

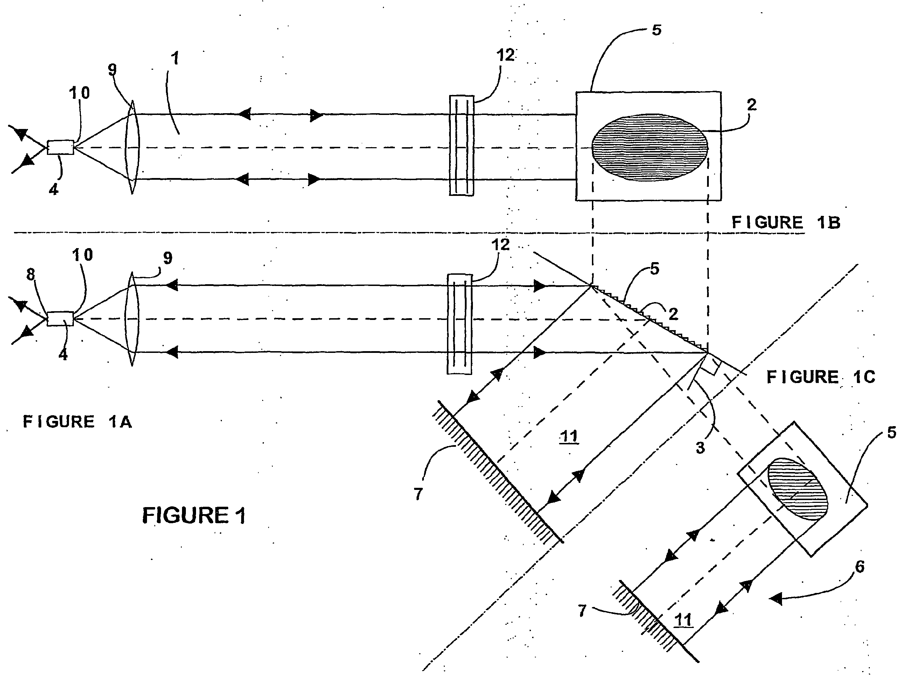

La Figure 1 représente un réseau 5 mis en oeuvre selon le montage de Littman-Metcalf dans lequel une extrémité 10 d'un milieu amplificateur monomode guidé 8 est placée au foyer d'une optique de collimation 9 qui produit un faisceau collimaté principal 1 de longueur d'onde λ.

Ce faisceau est parallèle au plan de dispersion du réseau, c'est-à-dire au plan perpendiculaire aux traits 2 du réseau 5, et forme un angle $\theta_1$ avec la normale 3 à la surface du réseau 5. Par diffraction sur le réseau, le faisceau 1 produit un faisceau collimaté secondaire 11 qui est dans le plan de dispersion et forme un angle $\theta_2$ avec la normale 3. Un miroir plan 7 est placé perpendiculairement au faisceau 11 et le faisceau se rétroréfléchit à travers l'ensemble du système.

On sait dans ces conditions que p étant le pas du réseau, lorsque la relation $p \sin \theta_1 + p \sin \theta_2 = \lambda$ est vérifiée, le faisceau 1 revient sur lui-même après une première diffraction sur le réseau 5, une rétroréflexion sur le miroir 7 et une deuxième diffraction sur le réseau 5. Il produit donc un point-image confondu avec l'extrémité 10.

On peut donc ainsi réaliser des sources laser accordables, l'accordabilité étant obtenue par le réglage du système dispersif rétroréfléchissant. Un tel dispositif est connu de US 5 594 744.

Toutefois, de tels dispositifs peuvent générer des sauts de modes. En effet, la rotation du dispositif dispersif à réseau change la longueur d'onde sélectionnée mais cette longueur d'onde doit aussi respecter la condition de résonance de toute cavité optique qui indique que la longueur optique $L_{op}$ de la cavité (en aller simple) est égale à un nombre entier N de demi-longueur d'onde :

$$L_{op} = N \cdot \lambda / 2$$

Si la longueur d'onde sélectionnée diminue, il faut donc raccourcir en même temps la cavité, et inversement la rallonger quand la longueur d'onde augmente, pour rester sur le même nombre entier N et éviter les sauts de modes.

Un dispositif d'accordabilité continue sans saut de mode a été proposé avec une configuration de Littrow (distincte de la configuration de Littman-Metcalf (F. Favre et D. Le Guen, "82 nm of continuous tunability for an external cavity semi-conductor laser", Electronics Letters, Vol. 27, 183-184, [1991]), mais il nécessite un ensemble mécanique complexe utilisant deux mouvements de translation et deux mouvements de rotation.

Dans un article de 1981, Liu et Littman (Optics Letters, vol. 6, N° 3, Mars 1981, pp. 117-118) décrivent un dispositif comportant un réseau et un miroir d'orientation variable mis en oeuvre pour la réalisation d'un laser monomode de longueur d'onde variable. La géométrie proposée permet d'assurer un balayage en longueur d'onde sans rupture.

Par ailleurs, les dièdres réflecteurs ont été étudiés de longue date. En particulier, la demande de brevet japonais JP-A-57.099793 du 21 Juin 1981 propose d'utiliser un tel dièdre pour réaliser un dispositif dispersif rétroréfléchissant dans un système de communication à fibre optique multiplexé en longueurs d'onde, ces longueurs d'onde sont fixes.

On connaît également une telle source laser monomode accordable en continu décrite dans la demande de brevet européen 0.702.438 qui utilise une configuration de Littman-Metcalf.

On connaît encore par la demande de brevet français 2.775.390 une source laser monomode continûment accordable en longueur d'onde comportant des moyens d'asservissement de la position du dispositif dispersif rétroréfléchissant par rapport à la longueur d'onde d'émission, de façon à limiter les sauts de mode lors de la variation de la longueur d'onde.

Les différents dispositifs de l'art antérieur produisent des résultats satisfaisants, la variation de la longueur d'onde n'occasionnant que peu de sauts de mode. Toutefois, le but de la présente invention est d'améliorer encore les performances de ces sources.

On connaît par ailleurs les avantages procurés par la mise en oeuvre d'un cristal photo-réfractif dans une cavité laser (J.M. Ramsey et W.B. Whitten - Optics Letters - Novembre 1987, Vol. 12, N° 11).

Un tel cristal placé à l'intérieur d'une cavité laser est soumis aux ondes se propageant à l'intérieur de la cavité qui, en interférant, produisent à l'intérieur du cristal des franges fonction de la longueur d'onde, les franges induisant des variations d'indice constituant un réseau de Bragg.

Il a été montré par exemple dans l'article cité plus haut que la présence d'un tel composant permet d'affiner le spectre du flux lumineux produit par le laser.

Un tel composant a donc été jusqu'à présent considéré comme pouvant se substituer au réseau du système dispersif rétroréfléchissant décrit plus haut, présentant de surcroît l'avantage d'une auto-adaptation sur la fréquence d'émission du laser.

L'invention concerne donc une source laser monomode accordable en longueur d'onde, à cavité externe, comportant une cavité résonnante ayant une face plane réfléchissante, des moyens d'extraction d'une partie du flux lumineux et un dispositif dispersif rétroréfléchissant, au moins un guide d'onde amplificateur placé à l'intérieur de la cavité résonnante, des moyens de contrôle du dispositif dispersif rétroréfléchissant assurant l'accordabilité continue.

La face plane de la cavité peut être totalement ou partiellement réfléchissante. Dans ce dernier cas, elle constitue également les moyens d'extraction d'une partie du flux lumineux.

Selon l'invention, cette source laser monomode comporte un composant photo-réfractif placé dans la cavité, sensible à la longueur d'onde de la source laser, au sein duquel est formé un réseau de Bragg.

Il ressortira de la description détaillée qu'une telle disposition procure non seulement un affinement de la répartition spectrale du flux lumineux produit par la source mais aussi qu'elle limite les possibilités du saut de mode, lors de la variation de la longueur d'onde. Il en résulte soit une meilleure stabilité de la source, soit un assouplissement du respect des conditions de fabrication habituellement requises.

Dans différents modes de réalisation présentant chacun des avantages spécifiques et susceptibles d'être combinés dans différentes configurations possibles, cette source laser monomode présente les caractéristiques suivantes :

- le composant photo-réfractif est un cristal d'arséniure de gallium (GaAs),
- le composant photo-réfractif est un cristal de tellure de cadmium (CdTe),
- le composant photo-réfractif est placé approximativement à une distance optique égale de chacun des réflecteurs de la cavité résonnante du laser,
- le dispositif dispersif rétroréfléchissant est dans la configuration de Littman-Metcalf,
- le miroir du dispositif rétroréfléchissant est un dièdre assurant l'auto-alignement du faisceau dans la direction perpendiculaire à l'étalement du spectre,
- le dispositif rétroréfléchissant comporte un ensemble constitué par un objectif et un dièdre réflecteur d'arête perpendiculaire au plan de dispersion du réseau formant un ensemble réflecteur auto-aligné à une dimension,
- le dispositif dispersif rétroréfléchissant est dans la configuration de Littrow,
- la source est continûment accordable,
- la source laser monomode comporte plusieurs guides d'onde amplificateurs, un seul composant photoréfractif et des moyens de sélection du guide d'onde amplificateur déterminant la longueur d'onde d'émission de la source,
- le guide d'onde amplificateur est une diode laser dont l'une des extrémités constitue la face de sortie du laser,
- la source laser produit un faisceau dont la longueur d'onde varie au voisinage de 1550 nm,
- la source laser comporte un asservissement du dispositif dispersif rétroréfléchissant en fonction de la longueur d'onde d'émission du laser.

L'invention sera décrite ci-après en détail en référence aux dessins annexés dans lesquels :

- la figure 1 est une représentation schématique de la source laser de l'invention :

  • la figure 1A étant une vue de dessus,
  • la figure 1B étant une vue de côté de l'un des bras de la source,

- la figure 1C étant une vue de côté de l'autre bras de cette source ;

- la figure 2 est une représentation des modes du flux lumineux produit par la source :

  - la figure 2A est une représentation des modes de la cavité de Fabry-Perot du laser,
  - la figure 2B est une représentation des modes produits par la source, selon l'art antérieur, en l'absence de composant photo-réfractif,
  - la figure 2C est une représentation séparée des effets séparée du système dispersif et du composant photo-réfractif;
  - la figure 2D est une représentation des modes sélectionnés selon l'invention;

- la figure 3 est une représentation comparative des performances de la source,

  - la figure 3A représente le domaine de fonctionnement d'une source laser accordable classique,
  - la figure 3B représente le domaine de fonctionnement d'une source accordable conforme à l'invention munie d'un composant photo-réfractif en tellure de cadmium,
  - la figure 3C représente le domaine de fonctionnement d'une source accordable conforme à l'invention munie d'un composant photo-réfractif en arséniure de gallium.

Les composants traditionnels d'une source accordable ont été décrits plus haut par rapport à l'art antérieur et sont représentés sur la figure 1 avec la même numérotation.

Selon l'invention, un composant photo-réfractif 12 est placé dans la cavité.

Un tel composant photo-réfractif est quelquefois qualifié de dynamique, il est soumis aux ondes lumineuses stationnaires présentes dans la cavité du laser qui y inscrivent un réseau de Bragg dont les caractéristiques sont liées à leur longueur d'onde. Lorsque cette longueur d'onde varie, le réseau de Bragg évolue, la période de ces franges étant modifiée.

La présence d'un tel composant photo-réfractif 12 engendre des phénomènes physiques qui peuvent être interprétés en considérant que celui-ci joue un rôle de filtre sur le ou les flux lumineux présents dans la cavité. En fait, plusieurs modes étant toujours présents dans la cavité, un mode central et des modes adjacents, ce composant photo-réfractif 12 affaiblit les modes adjacents et favorise simultanément le mode central.

On obtient ainsi la sélection de modes déjà décrite dans l'art antérieur et permettant d'obtenir une source d'une pureté spectrale plus importante. En plus de cet effet, il a été constaté que dans une source accordable, ce composant photo-réfractif 12 évolue en même temps que la variation de la longueur d'onde, même dans un domaine spectral relativement étendu, et qu'ainsi, non seulement il contribue à améliorer la pureté spectrale de la source mais de plus il évite certains sauts de mode résiduels qui auraient pu se produire lors du balayage en longueur d'onde de la source malgré les différents dispositifs mis en oeuvre pour éviter de tels sauts.

On n'avait jusqu'à présent pas envisagé la mise en oeuvre en plus d'un dispositif dispersif 5 au sein de la cavité d'un laser accordable qui a pour effet d'affiner le spectre et, sous certaines conditions, d'éviter les sauts de mode, et un deuxième dispositif dispersif tel que le composant photo-réfractif 12 ayant des propriétés complémentaires.

Toutefois, l'expérience a montré la possibilité d'obtenir des effets cumulatifs de sélection, d'une part, par le réseau du système dispersif rétroréfléchissant 5, 7 et, d'autre part, par le composant photo-réfractif 12.

Ces effets peuvent être obtenus avec un composant photoréfractif 12 unique alors même que la longueur d'onde d'émission est variable.

Pour cela, le laser peut mettre en oeuvre une cavité de Littman-Metcalf ou une cavité de Littrow permettant aussi d'assurer l'accordabilité continue. Il peut aussi être réalisé avec plusieurs guides d'onde amplificateurs actionnés chacun leur tour en fonction de la longueur d'onde d'émission recherchée. Dans ce cas encore, il a été constaté qu'il est possible de n'utiliser qu'un seul composant photoréfractif.

On a constaté que ce cumul d'effets est optimisé lorsque le composant photo-réfractif 12 est placé à une distance optique égale de chacun des réflecteurs, respectivement 8 et 7, de la cavité résonnante du laser.

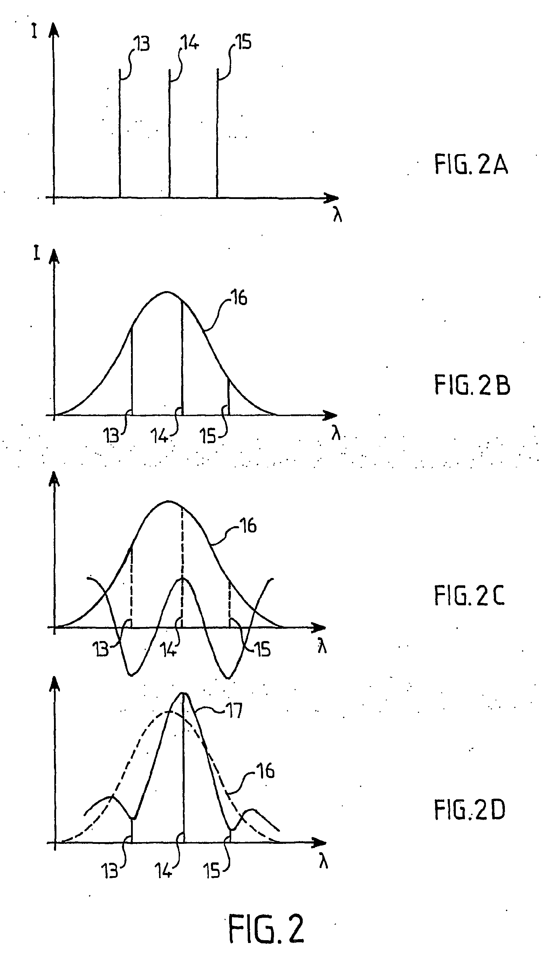

Une représentation possible de cette situation est donnée sur la figure 2 où l'axe des abscisses est la longueur d'onde et l'axe des ordonnées l'intensité lumineuse, où les modes 13, 14, 15 de la cavité de Fabry-Perot du laser représentés sur la figure 2A sont affectés par la mise en oeuvre du seul réseau 5 qui a une courbe 16 de réponse gaussienne telle que représentée sur la figure 2B.

La mise en oeuvre du composant photo-réfractif 12, lorsqu'il est placé à mi-distance des réflecteurs 8, 7 de la cavité de Fabry-Perot, a un effet 17 sinusoïdal dont la période est le double de l'espacement des modes de la cavité de Fabry-Perot, qui contribue donc par amplification de la longueur d'onde du mode dominant à améliorer l'amplification de celui-ci aux dépens des modes adjacents qui sont affaiblis de manière maximale lorsque le composant photo-réfractif est mis en cette position. Cet effet du composant photo-réfractif 12 est représenté isolément par rapport à la courbe de réponse du réseau sur la figure 2C et cumulativement avec lui sur la figure 2D.

On augmente ainsi la puissance du mode principal relativement aux modes adjacents.

L'invention est avantageusement mise en oeuvre pour la réalisation d'une source utilisable pour les tests de réseaux de télécommunications par fibres optiques, par exemple dans le proche infrarouge à des longueurs d'onde variant au voisinage de 1550 nm.

On a obtenu de bons résultats en réalisant le composant photo-réfractif, soit à partir d'un cristal d'arséniure de gallium, soit à partir d'un cristal de tellure de cadmium. Ces cristaux sont particulièrement efficaces dans le domaine de longueur d'onde mentionné plus haut.

L'invention peut être mise en oeuvre avec différents types de sources accordables que le dispositif dispersif rétroréfléchissant soit dans la configuration de Littrow ou dans la configuration de Littman-Metcalf.

Les différents perfectionnements permettant d'améliorer la stabilisation de la source accordable et d'éviter les sauts de mode peuvent avantageusement être combinés avec la présente invention, en particulier on a amélioré le fonctionnement d'une telle source en utilisant un dièdre comme miroir du dispositif rétroréfléchissant. Ce dièdre assure l'auto-alignement du faisceau dans la direction perpendiculaire à l'étalement du spectre.

Dans un autre mode de réalisation, le dispositif rétroréfléchissant comporte un ensemble formé par un objectif et un dièdre réflecteur d'arête perpendiculaire au plan de dispersion du réseau. Cet ensemble forme un réflecteur auto-aligné à une dimension.

En vue d'une bonne stabilisation du faisceau lumineux, nous avons vu que le positionnement du cristal photo-réfractif, à mi-chemin environ de la cavité, est déterminant. Cette position permet en effet de se prémunir contre un éventuel saut de mode engendré par la cavité de Fabry-Perot formée par l'antireflet du milieu amplificateur et le réseau. Le couplage entre cette petite cavité et la grande est une source d'instabilité.

Il existe cependant une autre source éventuelle de saut de mode pour le faisceau lumineux.

L'allongement de la cavité entraîne en effet un couplage plus fort entre les modes et une sélectivité plus faible du réseau. Il faut donc déterminer dans quelles conditions le fonctionnement s'effectue sans saut de mode.

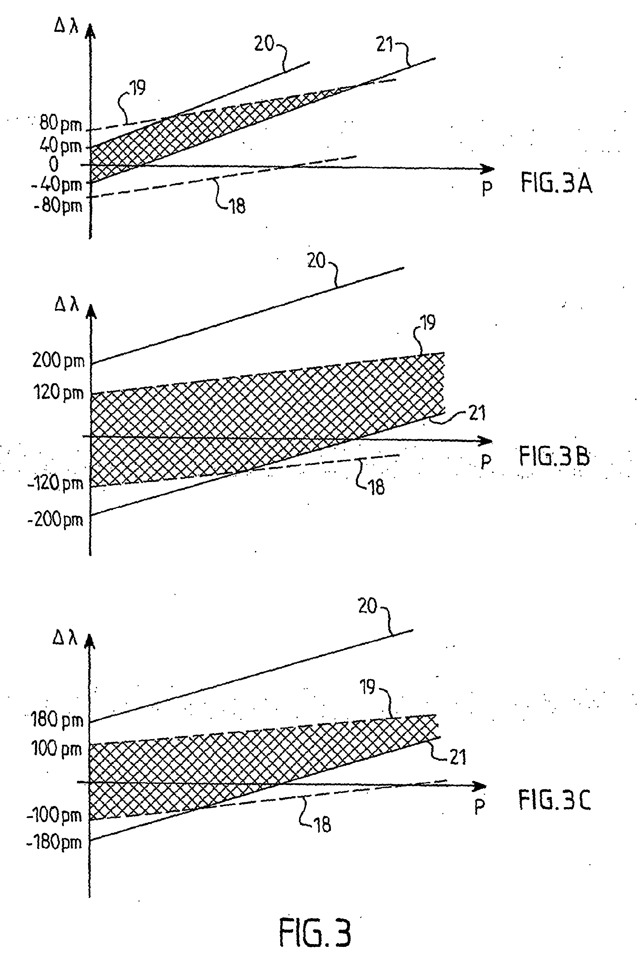

Les figures 3A, 3B et 3C montrent les domaines de fonctionnement possibles, sans saut de mode, pour une cavité sans cristal photo-réfractif (3A) ou, selon l'invention, avec un cristal d'arséniure de gallium (3C), respectivement avec un cristal de tellure de cadmium (3B). Sur ces figures l'axe des abscisses représente la puissance de sortie de la source, l'axe des ordonnées le décalage en longueur d'onde du mode principal par rapport au maximum de transmission du réseau.

Les courbes 18 et 19 représentent les limites d'apparition d'un saut de mode double, et les courbes 20 et 21, les limites d'apparition d'un saut de mode . La source est donc stable tant que le point de fonctionnement est à l'intérieur de la zone 22 délimitée par ces courbes.

On constate donc une augmentation significative de la surface de cette zone 22 de fonctionnement stable lors de l'utilisation d'un cristal photo-réfractif selon l'invention (figures 3B et 3C).

On s'aperçoit sur les figures 3B et 3C que l'introduction dans la cavité d'un cristal photo-réfractif de type tellure de cadmium permet une limitation des sauts de mode importante vis-à-vis de la cavité sans composant. Le domaine de fonctionnement est considérablement élargi.

La valeur des paramètres pris en compte pour obtenir les figures 3A, 3B et 3C est la suivante : longueur de la cavité formée par l'antireflet et le réseau de l'ordre de 30 mm, épaisseur du cristal de tellure de cadmium ou du cristal d' arséniure de gallium de l'ordre de 4 mm.

**Revendications**

1. Source laser monomode accordable en longueur d'onde à cavité externe comportant :

   - une cavité résonnante 1 ayant une face plane réfléchissante 8, des moyens d'extraction d'une partie du flux lumineux et un dispositif dispersif rétroréfléchissant 11,
   - au moins un guide d'onde amplificateur placé à l'intérieur de la cavité résonnante 4,
   - des moyens de contrôle du dispositif dispersif rétroréfléchissant assurant l'accordabilité continue,

   **caractérisée en ce qu'**elle comporte un composant photo-réfractif placé dans la cavité 12, sensible à la longueur d'onde de la source laser, au sein duquel est formé un réseau de Bragg.

2. Source laser monomode accordable en longueur d'onde selon la revendication 1, **caractérisée en ce que** le composant photo-réfractif est un cristal d'arséniure de gallium (GaAs).

3. Source laser monomode accordable en longueur d'onde selon la revendication 2, **caractérisée en ce que** le composant photo-réfractif est un cristal de tellure de cadmium (CdTe).

4. Source laser monomode accordable en longueur d'onde selon l'une quelconque des revendications 1 à 3, **caractérisée en ce que** le composant photoréfractif est placé approximativement à une distance optique égale de chacun des réflecteurs de la cavité résonnante du laser.

5. Source laser monomode accordable en longueur d'onde selon l'une quelconque des revendications 1 à 4, **caractérisée en ce que** le dispositif dispersif rétroréfléchissant est dans la configuration de Littman-Metcalf.

**6.** Source laser monomode accordable en longueur d'onde selon la revendication 5, **caractérisée en ce que** le miroir du dispositif rétroréfléchissant est un dièdre assurant l'auto-alignement du faisceau dans la direction perpendiculaire à l'étalement du spectre.

**7.** Source laser monomode accordable en longueur d'onde selon la revendication 6, **caractérisée en ce que** le dispositif rétroréfléchissant comporte un ensemble constitué par un objectif et un dièdre réflecteur d'arête perpendiculaire au plan de dispersion du réseau formant un ensemble réflecteur auto-aligné à une dimension.

**8.** Source laser monomode accordable en longueur d'onde selon l'une quelconque des revendications 1 à 4, **caractérisée en ce que** le dispositif dispersif rétroréfléchissant est dans la configuration de Littrow.

**9.** Source laser monomode accordable en longueur d'onde selon l'une quelconque des revendications 1 à 8, **caractérisée en ce que** la source est continûment accordable.

**10.** Source laser monomode accordable en longueur d'onde selon l'une quelconque des revendications 1 à 4, **caractérisée en ce qu'**elle comporte plusieurs guides d'onde amplificateurs, un seul composant photoréfractif et des moyens de sélection du guide d'onde amplificateur déterminant la longueur d'onde d'émission de la source.

**11.** Source laser monomode accordable en longueur d'onde selon l'une quelconque des revendications 1 à 10, **caractérisée en ce que** le guide d'onde amplificateur est une diode laser dont l'une des extrémités constitue la face de sortie du laser.

**12.** Source laser monomode accordable en longueur d'onde selon l'une quelconque des revendications 1 à 11, **caractérisée en ce qu'**elle produit un faisceau dont la longueur d'onde varie au voisinage de 1550 nm.

**13.** Source laser monomode accordable en longueur d'onde selon l'une quelconque des revendications 1 à 12, **caractérisée en ce qu'**elle comporte un asservissement du dispositif dispersif rétroréfléchissant en fonction de la longueur d'onde d'émission du laser.

**Claims**

**1.** Wavelength tunable monomode laser source with an external cavity comprising:

- a resonating cavity 1 having a reflective planar surface 8, means for extracting part of the luminous flux and a retro-reflective dispersive device 11,
- at least one amplifying waveguide placed inside the resonating cavity 4,
- means for controlling the retro-reflective dispersive device ensuring continuous tuneability,

**characterised in that** it comprises a light-refracting component placed in the cavity 12, sensitive to the wavelength of the laser source, within which is formed a Bragg grating.

**2.** Wavelength tunable monomode laser source according to claim 1, **characterised in that** the light-refracting component is a crystal of gallium arsenide (GaAs).

**3.** Wavelength tunable monomode laser source according to claim 2, **characterised in that** the light-refracting component is a crystal of cadmium telluride (CdTe).

**4.** Wavelength tunable monomode laser source according to any one of claims 1 to 3, **characterised in that** the light-refracting component is placed at approximately the same optical distance from each of the reflectors of the resonating cavity of the laser.

**5.** Wavelength tunable monomode laser source according to any one of claims 1 to 4, **characterised in that** the retro-reflective dispersive device is in the Littman-Metcalf configuration.

**6.** Wavelength tunable monomode laser source according to claim 5, **characterised in that** the mirror of the retro-reflective device is a dihedron ensuring auto-alignment of the beam in the direction perpendicular to the spread of the spectrum.

**7.** Wavelength tunable monomode laser source according to claim 6, **characterised in that** the retro-reflective device comprises an assembly consisting of an objective and a reflective dihedron, the edge of which is perpendicular to the plane of dispersion of the grating forming a reflective assembly which is auto-aligned with one dimension.

**8.** Wavelength tunable monomode laser source according to any one of claims 1 to 4, **characterised in that** the retro-reflective dispersive device is in the Littrow configuration.

**9.** Wavelength tunable monomode laser source according to any one of claims 1 to 8, **characterised in that** the source is continuously tunable.

**10.** Wavelength tunable monomode laser source according to any one of claims 1 to 4, **characterised in that** it comprises a plurality of amplifying waveguides, a single light-refracting component and means for selecting the amplifying waveguide that determine the emission wavelength of the source.

**11.** Wavelength tunable monomode laser source according to any one of claims 1 to 10, **characterised in that** the amplifying waveguide is a laser diode one end of which constitutes the output surface of the laser.

**12.** Wavelength tunable monomode laser source according to any one of claims 1 to 11, **characterised in that** it produces a beam, the wavelength of which varies around 1550 nm.

**13.** Wavelength tunable monomode laser source according to any one of claims 1 to 12, **characterised in that** it comprises an enslavement of the retro-reflective dispersive device as a function of the emission wavelength of the laser.


**Patentansprüche**

**1.** Monomode-Laserquelle mit abstimmbarer Wellenlänge mit äußerem Hohlraum, die Folgendes umfasst:

> - einen Resonanzhohlraum 1, der eine reflektierende ebene Fläche 8, Mittel zur Extraktion eines Anteils des Lichtstroms und eine retroreflektierende dispersive Vorrichtung 11 aufweist,
> - mindestens einen verstärkenden Wellenleiter, der im Inneren des Resonanzhohlraums 4 angebracht ist,
> - Mittel zur Steuerung der retroreflektierenden dispersiven Vorrichtung, die die kontinuierliche Abstimmbarkeit sicherstellen,
>
> **dadurch gekennzeichnet, dass** sie ein im Hohlraum 12 angebrachtes photorefraktives Bauteil umfasst, das für die Wellenlänge der Laserquelle empfindlich ist, in dem ein Braggsches Gitter gebildet ist.

**2.** Monomode-Laserquelle mit abstimmbarer Wellenlänge nach Anspruch 1, **dadurch gekennzeichnet, dass** das photorefraktive Bauteil ein Kristall aus Galliumarsenid (GaAs) ist.

**3.** Monomode-Laserquelle mit abstimmbarer Wellenlänge nach Anspruch 2, **dadurch gekennzeichnet, dass** das photorefraktive Bauteil ein Kristall aus Cadmiumtellurid (CdTe) ist.

**4.** Monomode-Laserquelle mit abstimmbarer Wellenlänge nach einem der Ansprüche 1 bis 3, **dadurch gekennzeichnet, dass** das photorefraktive Bauteil etwa in einer gleichen optischen Weglänge von jedem der Reflektoren des Resonanzhohlraums des Lasers angebracht ist.

**5.** Monomode-Laserquelle mit abstimmbarer Wellenlänge nach einem der Ansprüche 1 bis 4, **dadurch gekennzeichnet, dass** die retroreflektierende dispersive Vorrichtung in der Littman-Metcalf-Konfiguration angeordnet ist.

**6.** Monomode-Laserquelle mit abstimmbarer Wellenlänge nach Anspruch 5, **dadurch gekennzeichnet, dass** der Spiegel der retroreflektierenden Vorrichtung ein V-Winkel ist, der die Selbstausrichtung des Strahls in der Richtung senkrecht zur Spreizung des Spektrums sicherstellt.

**7.** Monomode-Laserquelle mit abstimmbarer Wellenlänge nach Anspruch 6, **dadurch gekennzeichnet, dass** die retroreflektierende Vorrichtung einen Zusammenbau umfasst, der aus einem Objektiv und einem Winkelreflektor mit einer Kante besteht, die senkrecht zur Dispersionsebene des Gitters ist, wodurch ein in einer Dimension selbstausgerichteter Reflektorzusammenbau gebildet wird.

**8.** Monomode-Laserquelle mit abstimmbarer Wellenlänge nach einem der Ansprüche 1 bis 4, **dadurch gekennzeichnet, dass** die retroreflektierende dispersive Vorrichtung in der Littrow-Konfiguration angeordnet ist.

**9.** Monomode-Laserquelle mit abstimmbarer Wellenlänge nach einem der Ansprüche 1 bis 8, **dadurch gekennzeichnet, dass** die Quelle kontinuierlich abstimmbar ist.

**10.** Monomode-Laserquelle mit abstimmbarer Wellenlänge nach einem der Ansprüche 1 bis 4, **dadurch gekennzeichnet, dass** sie mehrere verstärkende Wellenleiter umfasst, wobei ein einziges photorefraktives Bauteil und Mittel zur Auswahl des verstärkenden Wellenleiters die Emissionswellenlänge der Quelle bestimmen.

**11.** Monomode-Laserquelle mit abstimmbarer Wellenlänge nach einem der Ansprüche 1 bis 10, **dadurch gekennzeichnet, dass** der verstärkende Wellenleiter eine Laserdiode ist, von der eines der Enden die Austrittsfläche des Lasers bildet.

**12.** Monomode-Laserquelle mit abstimmbarer Wellenlänge nach einem der Ansprüche 1 bis 11, **dadurch gekennzeichnet, dass** sie einen Strahl erzeugt, dessen Wellenlänge in der Nähe von 1550 nm variiert.

**EP 1 327 289 B1**

**13.** Monomode-Laserquelle mit abstimmbarer Wellenlänge nach einem der Ansprüche 1 bis 12, **dadurch gekennzeichnet, dass** sie eine Regelung der retroreflektierenden dispersiven Vorrichtung in Abhängigkeit von der Emissionswellenlänge des Lasers umfasst.

FIGURE 1B

FIGURE 1C

FIGURE 1A

FIGURE 1

FIG. 2A

FIG. 2B

FIG. 2C

FIG. 2D

FIG. 2

FIG.3A

FIG.3B

FIG.3C

FIG.3

## RÉFÉRENCES CITÉES DANS LA DESCRIPTION

**Documents brevets cités dans la description**

- US 5594744 A
- JP 57099793 A
- EP 0702438 A
- FR 2775390

**Littérature non-brevet citée dans la description**

- **F. Favre ; D. Le Guen.** 82 nm of continuous tunability for an external cavity semi-conductor laser. *Electronics Letters,* 1991, vol. 27, 183-184
- **Liu ; Littman.** *Optics Letters,* Mars 1981, vol. 6 (3), 117-118
- **J.M. Ramsey ; W.B. Whitten.** *Optics Letters,* Novembre 1987, vol. 12 (11